# EUROPÄISCHE PATENTANMELDUNG

(11) **EP 3 109 654 A1**
(43) Veröffentlichungstag der Anmeldung: **28.12.2016**
(21) Anmeldenummer: 15173504.0
(22) Anmeldetag: 24.06.2015
(51) Int. Cl.: G01R 31/36, H01M 10/42, H02J 7/00

(54) **VERFAHREN ZUM ERMITTELN EINES LADUNGSSPEICHERVERMÖGENS EINES AKKUS**

(71) Anmelder: HILTI Aktiengesellschaft, 9494 Schaan (LI)
(72) Erfinder: BRANDNER, Michael, 86807 Buchloe (DE); ZIEGLER, Bernd, 86856 Hiltenfingen (DE); LUDWIG, Hubert, 86899 Landsberg / Lech (DE)

(57) **Zusammenfassung**

Verfahren zum Ermitteln eines Ladungsspeichervermögens eines Akkus, insbesondere eines Handwerkzeugakkus, gekennzeichnet durch die Schritte des Ermittelns eines Kapazitäts-Kennwerts, der ein Ladungsspeichervermögen des Akkus repräsentiert, durch ein Akku-Ladegerät, und des Einspeicherns des durch das Akku-Ladegerät ermittelten Kapazitäts-Kennwerts in eine Speicherelektronik des Akkus.

## Beschreibung

Die vorliegende Erfindung betrifft ein Verfahren zum Ermitteln eines Ladungsspeichervermögens (Akku-Kapazität) eines Akkus, insbesondere eines Handwerkzeugakkus. Die Erfindung betrifft ebenfalls einen Akku, insbesondere einen Handwerkzeugakku. Des Weiteren betrifft die vorliegende Erfindung ein Akku-Ladegerät zum Laden eines Akkus sowie ein Ladesystem mit einem Akku und einem Ladegerät.

Es ist Aufgabe der vorliegenden Erfindung, ein Verfahren sowie einen Akku, ein Akku-Ladegerät sowie ein Ladesystem anzugeben, das eine schnelle Ermittlung eines Ladespeichervermögens eines Akkus, insbesondere im Reparaturfall, ermöglicht.

Bezüglich des Verfahrens wird die Aufgabe durch ein Verfahren zum Ermitteln eines Ladungsspeichervermögens eines Akkus, insbesondere eines Handwerkzeugakkus, gelöst wobei das Verfahren die Schritte aufweist:
- Ermitteln eines Kapazitäts-Kennwerts, der ein Ladungsspeichervermögen des Akkus repräsentiert, durch ein Akku-Ladegerät, und
- Einspeichern des durch das Akku-Ladegerät ermittelten Kapazitäts-Kennwerts in einer Speicherelektronik des Akkus.

Die Erfindung schließt die Erkenntnis ein, dass ein Ladungsspeichervermögen eines Akkus im Laufe der Lebensdauer des Akkus abnimmt und dass es im Sinne einer zeitlich effizienten und damit auch aus Kostensicht effizienten Abwicklung einer Akkureparatur in einem Reparaturzentrum erforderlich ist, möglichst sofort ein Ladungsspeichervermögen eines Akkus zu ermitteln. Dadurch, dass erfindungsgemäß ein Einspeichern des durch das Akku-Ladegerät ermittelten Kapazitäts-Kennwerts in einer Speicherelektronik des Akkus erfolgt, kann ohne eine langwierige Ermittlung des Ladespeichervermögens verzichtet werden und sofort auf einen ermittelten Kapazitäts-Kennwert, der eine vergleichsweise geringe Toleranz aufweist, zugegriffen werden. Auf eine Bestimmung des Kapazitäts-Kennwerts über eine aufwändige Auswertung von Lade- und Entladeparametern sowie gemessenen Strom- und Spannungskennwerten kann verzichtet werden.

In einer besonders bevorzugten Ausgestaltung erfolgt ein Auslesen des in die Speicherelektronik des Akkus eingespeicherten Kapazitäts-Kennwerts durch das Akku-Ladegerät oder ein Akku-Diagnosegerät. Vorteilhafterweise kann nun ein Kapazitäts-Kennwert des Akkus schnell bestimmt werden.

Ein Ermitteln des Kapazitäts-Kennwerts im Zuge des erfindungsgemäßen Verfahrens kann beispielsweise durch Messung eines an den Akku anzulegenden bzw. eingespeisten Ladestroms und dessen Multiplikation einer Ladedauer erfolgen. Alternativ oder zusätzlich kann ein Ermitteln des Kapazitäts-Kennwerts durch sogenanntes "impedance tracking" o. ä. erfolgen. Ein Ladezustand kann auf bekannte Art und Weise beispielsweise mittels der Ruhespannungsmethode oder mittels Innenwiderstandsmessung erfolgen. Ein Ladezustand wird der typischerweise als "state of charge" (SOC) bezeichnet, wobei SOC = 1 oder SOC 100% einen vollgeladenen Akkus bezeichnet. SOC = 0 oder SOC = 0 % bezeichnet hingegen einen vollständig entladenen Akku. Ein Akku kann als entladen definiert sein bzw. durch ein Akku-Ladegerät als entladen erkannt werden, wenn die Bedingung SOC < 0,1 bzw. SOC < 10 % vorliegt.

In einer besonders bevorzugten Weiterbildung wird der Kapazitäts-Kennwert während eines Normalladevorgangs ermittelt. Bevorzugt ist der Normalladevorgang definiert durch ein Aufladen des Akkus von einem Ladezustand unterhalb eines in dem Akku-Ladegerät vorgegebenen Entladeschwellwerts bis zum Erreichen eines Endladezustands, für den im Akku-Ladegerät eine Abschaltschwelle vorgegeben ist. Ein vorgegebener Entladeschwellwert kann beispielsweise ein SOC = 0,1 sein. Eine Abschaltschwelle kann beispielsweise eine Ladestromschwelle sein. Ein Abschalten des Ladebetriebs erfolgt demgemäß, wenn ein momentaner Ladestrom, mit dem der Akku geladen wird, im Zuge des Ladevorgangs die vorgegebene Abschaltschwelle unterschreitet. Der Kapazitäts-Kennwert kann die Einheit Amperestunden (Ah) aufweisen und wird bevorzugt berechnet über den Ladestrom multipliziert mit der Zeit, die der Normalladevorgang andauert.

Ein Ermitteln des Kapazitäts-Kennwerts kann bei jedem Ladevorgang, insbesondere bei jedem Normalladevorgang erfolgen bzw. wiederholt werden.

Es hat sich als vorteilhaft herausgestellt, wenn das Verfahren ein Inkrementieren eines in der Speicherelektronik des Akkus vorgesehenen Kapazitätsermittlungszählers aufweist. Bevorzugt repräsentiert der Kapazitätsermittlungszähler die Anzahl durchgeführter Ermittlungsvorgänge des Kapazitäts-Kennwerts. Besonders bevorzugt erfolgt ein Inkrementieren des Kapazitätsermittlungszählers, wenn der Ladevorgang, insbesondere der Normalladevorgang, abgeschlossen wurde. Das Inkrementieren des Kapazitätsermittlungszählers kann alternativ nur in dem Fall erfolgen, wenn der Normalladevorgang abgeschlossen wurde und/oder der Normalladevorgang unterbrechungsfrei abgeschlossen wurde.

Bevorzugt erfolgt ein Einspeichern des durch das Akku-Ladegerät ermittelten Kapazitäts-Kennwerts nur, wenn der Normalladevorgang abgeschlossen, bevorzugt unterbrechungsfrei, abgeschlossen wurde.

In einer weiteren bevorzugten Ausgestaltung sieht das Verfahren ein Inkrementieren eines in der Speicherelektronik des Akkus vorgesehenen Ladevorgangszählers vor. Bevorzugt repräsentiert der Ladevorgangszähler die Anzahl abgeschlossener Ladevorgänge. Ein Inkrementieren des Ladevorgangszählers kann erfolgen, wenn der Normalladevorgang oder ein Nachladevorgang unterbrechungsfrei abgeschlossen wurde. Unter einem Nachladevorgang ist bevorzugt ein Aufladen des Akkus ausgehend von einem Ladezustand oberhalb des in dem Akku-Ladegerät vorgegebenen Entladeschwellwerts bis zum Erreichen des Endladezustands zu verstehen. Ist der im Akku-Ladegerät vorgegebene Entladeschwellwert beispielsweise SOC = 0,1, so wird ein Akku mit einem beispielhaften SOC von 0,05 durch das Akku-Ladegerät als vollständig entladen (leer) erkannt. Beträgt der Ladezustand beispielsweise SOC = 0,2, so erfolgt ein Aufladen des Akkus oberhalb des vorgegebenen Entladeschwellwerts, somit ein Nachladevorgang.

In einer weiter bevorzugten Ausgestaltung des Verfahrens erfolgt ein Inkrementieren eines in der Speicherelektronik des Akkus vorgesehenen Ladeabbruchzählers, wenn der Normalladevorgang oder der Nachladevorgang vor Erreichen des Endladezustands abgebrochen wurde. Bevorzugt repräsentiert der Ladeabbruchzähler die Anzahl abgebrochener Ladevorgänge.

Gemäß einer weiteren vorteilhaften Weiterbildung sieht das Verfahren ein Inkrementieren eines in der Speicherelektronik des Akkus vorgesehenen Entladezustandszählers vor. Ein Inkrementieren erfolgt bevorzugt, wenn der Ladevorgang bei einem Ladezustand unterhalb des in dem Akku-Ladegerät vorgegebenen Entladeschwellwerts begonnen wird. In einer besonders bevorzugten Weiterbildung schließt das Verfahren ein Summieren der im Ladevorgangszähler gespeicherten Anzahl abgeschlossener Ladevorgänge mit der im Ladeabbruchzähler gespeicherten Anzahl abgebrochener Ladevorgänge ein. Bevorzugt erfolgt das Summieren in einen in der Speicherelektronik des Akkus vorgesehenen Gesamtladevorgangszähler. Bevorzugt erfolgt das Summieren nach, weiter bevorzugt nur nach dem Ermitteln und/oder Einspeichern des Kapazitäts-Kennwerts in die Speicherelektronik des Akkus.

Bevorzugt erfolgt ein Einspeichern des durch das Akku-Ladegerät ermittelten Kapazitäts-Kennwerts in die Speicherelektronik des Akkus nur, wenn der Normalladevorgang unterbrechungsfrei abgeschlossen wurde. Der ermittelte Kapazitäts-Kennwert kann im Falle einer Unterbrechung des Ladevorgangs, insbesondere des Normalladevorgangs, verworfen werden.

In einer weiteren bevorzugten Ausgestaltung erfolgt im Rahmen des Verfahrens ein Subtrahieren der im Ladeabbruchzähler gespeicherten Anzahl abgebrochener Ladevorgänge von einer Gesamtanzahl von Ladevorgängen, die im Gesamtladevorgangszähler gespeichert sind. Damit kann vorteilhafterweise bestimmt werden, wie viele Ladezyklen seit der jeweils letzten Ermittlung des Kapazitäts-Kennwerts vergangen ist. Somit kann beispielsweise im Reparaturfall die Aktualität des eingespeicherten Kapazitäts-Kennwerts ermittelt werden.

Bezüglich des Akkus wird die Aufgabe gelöst durch einen Akku, insbesondere einen Handwerkzeugakku mit einer Speicherelektronik, in die ein durch ein Akku-Ladegerät ermittelter Kapazitäts-Kennwert des Akkus eingespeichert werden kann. Die Speicherelektronik weist bevorzugt einen Kapazitätsermittlungszähler auf, der die Anzahl durchgeführter Ermittlungsvorgänge des Kapazitäts-Kennwerts repräsentiert. Weiter bevorzugt weist die Speicherelektronik einen Ladevorgangszähler auf, der die Anzahl abgeschlossener Ladevorgänge repräsentiert.

Die Speicherelektronik kann einen Ladeabbruchzähler aufweisen, der die Anzahl abgebrochener Ladevorgänge repräsentiert. In einer besonders bevorzugten Ausgestaltung weist die Speicherelektronik einen Entladezustandszähler auf, der die Anzahl der Ladevorgänge angibt, die bei einem Ladezustand des Akkus unterhalb des im Akku-Ladegerät vorgegebenen Entladeschwellwerts begonnen werden.

Der Akku kann durch die mit Bezug auf das Verfahren beschriebenen Merkmale weitergebildet sein.

Bezüglich des Akku-Ladegeräts wird die Aufgabe gelöst durch ein Akku-Ladegerät zum Laden eines Akkus, bevorzugt eines vorbeschriebenen Akkus. Das Akku-Ladegerät weist erfindungsgemäß eine Ladegerät-Schnittstelle auf, über die ein durch das Akku-Ladegerät ermittelter Kapazitäts-Kennwert, der ein Ladungsspeichervermögen des Akkus repräsentiert, an den Akku übertragen werden kann, bevorzugt zwecks eines Einspeicherns des ermittelten Kapazitäts-Kennwerts in eine Speicherelektronik.

Besonders bevorzugt ist das Akku-Ladegerät ausgebildet, den in die Speicherelektronik des Akkus eingespeicherten Kapazitäts-Kennwert auszulesen.

Die Erfindung wird ebenfalls gelöst durch ein Ladesystem mit einem vorbeschriebenen Akku und ein mit einem vorbeschriebenen Akku-Ladegerät. Bevorzugt ist das Ladesystem ausgebildet, ein vorbeschriebenes Verfahren zum Ermitteln eines Ladungsspeichervermögens eines Akkus, insbesondere eines Handwerkzeugakkus, auszuführen.

Weitere Vorteile ergeben sich aus der folgenden Figurenbeschreibung. In den Figuren sind verschiedene Ausführungsbeispiele der vorliegenden Erfindung dargestellt. Die Figuren, die Beschreibung und die Ansprüche enthalten zahlreiche Merkmale in Kombination. Der Fachmann wird die Merkmale zweckmässigerweise auch einzeln betrachten und zu sinnvollen weiteren Kombinationen zusammenfassen.

In den Figuren sind gleiche und gleichartige Komponenten mit gleichen Bezugszeichen beziffert.

Es zeigen:
- Fig. 1: ein Verfahren zum Ermitteln eines Ladungsspeichervermögens eines Akkus in Zusammenhang mit einem Normalladevorgang;
- Fig. 2: eine Ausgestaltung des Verfahrens bei einem Nachladevorgang;
- Fig. 3: eine Ausgestaltung des Verfahrens bei einem abgebrochenen Ladevorgang;
- Fig. 4: eine Ausgestaltung des Verfahrens bei einem abgebrochenen Nachladevorgang;
- Fig. 5: ein erfindungsgemäßes Ladesystem.

### Ausführungsbeispiele:

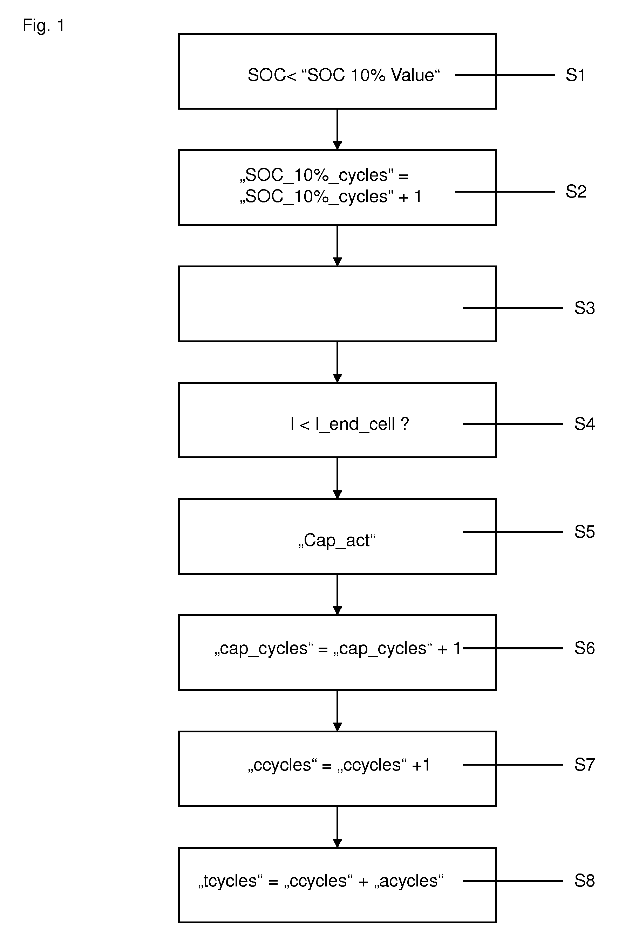

Bei den mit Bezug auf die Fig. 1 bis Fig. 4 beschriebenen Ausführungsbeispiele sei ein Entladeschwellwert mit SOC = 10% vorgegeben, d.h. ein Akku mit SOC < 10% wird als entladen angesehen und ein Akku mit SOC > 10% als nicht vollständig entladen angesehen.

In einem ersten Schritt S1 wird zunächst ein entladener Akku, das heißt SOC des Akkus < 10%, an ein Akku-Ladegerät angeschlossen. Da der Ladevorgang bei einem Ladezustand unterhalb des in dem Akku-Ladegerät vorgegebenen Entladeschwellwerts SOC_10%_value begonnen wird beziehungsweise zu beginnen ist, wird ein in der Speicherelektronik des Akkus vorgesehener Entladezustandszähler SOC_10%_cycles um den Zähler 1 inkrementiert. Dies erfolgt in einem Schritt S2.

In einem anschließenden Schritt S3 wird der Akku in einem Normalladevorgang geladen, das heißt der Akku wird von einem Ladezustand unterhalb des in dem Akku-Ladegerät vorgegebenen Entladeschwellwerts SOC_10%_value bis zum Erreichen eines Endladezustands, für den im Akku-Ladegerät eine Abschaltschwelle I_end_cell vorgegeben ist, durchgeführt. Gleichzeitig wird im Schritt S3 der Kapazitäts-Kennwerts Cap_act ermittelt.

Im vorliegenden Fall wird der Ladevorgang abgeschaltet, wenn der momentane Ladestrom I die Abschaltschwelle I_end_cell unterschreitet. Dies erfolgt im Schritt S4.

Da im vorliegenden Ausführungsbeispiel der Normalladezustand unterbrechungsfrei durchgeführt wurde, erfolgt in einem anschließenden Schritt S5 ein Einspeichern des durch das Akku-Ladegerät ermittelten Kapazitäts-Kennwerts Cap_act in die Speicherelektronik des Akkus.

Da im vorliegend dargestellten Ausführungsbeispiel der Normalladevorgang unterbrechungsfrei abgeschlossen wurde, wird auch der in der Speicherelektronik des Akkus vorgesehene Kapazitätsermittlungszähler cap_cycles, der die Anzahl durchgeführter Ermittlungsvorgänge des Kapazitäts-Kennwerts Cap_act repräsentiert, um 1 inkrementiert. Dies erfolgt im Schritt S6, der sich an den Schritt S5 anschließt.

In einem sich anschließenden Schritt S7 erfolgt ein Inkrementieren eines in der Speicherelektronik des Akkus vorgesehenen Ladevorgangszählers ccycles, der die Anzahl abgeschlossener Ladevorgänge repräsentiert, um den Wert 1. Dies, da der Normalladevorgang unterbrechungsfrei abgeschlossen wurde.

In einem sich anschließenden achten Schritt S8 erfolgt ein Summieren der im Ladevorgangszähler ccycles gespeicherten Anzahl abgeschlossener Ladevorgänge mit der im Ladeabbruchzähler acycles gespeicherten Anzahl abgebrochener Ladevorgänge in einem in der Speicherelektronik des Akkus vorgesehenen Gesamtladevorgangszähler tcycles. Der nunmehr vollgeladene Akku kann nun in einer Handwerkzeugmaschine verwendet werden. Das mit Bezug auf Fig. 1 beschriebene Verfahren wird bevorzugt bei jedem Normalladevorgang des Akkus wiederholt.

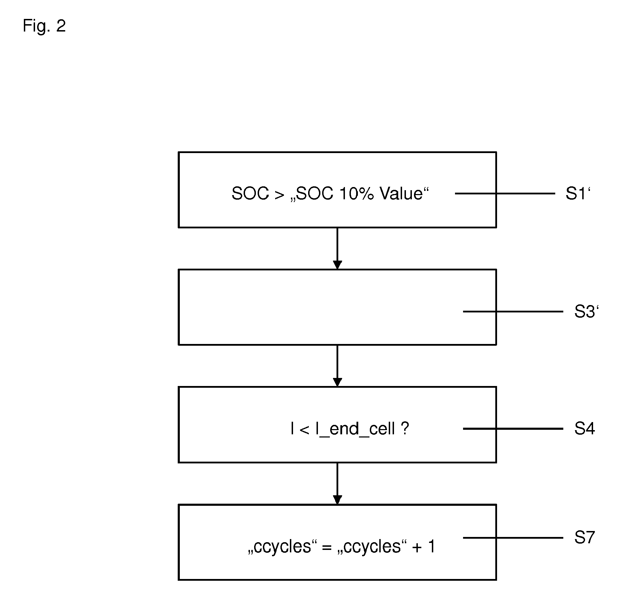

Fig. 2 zeigt nunmehr das Verfahren im Rahmen eines Nachladevorgangs. In einem Schritt S1' wird beispielhaft ein Akku mit einem SOC = 20% mit dem Akku-Ladegerät verbunden. Der momentane SOC des Akkus ist somit größer als der vorgegebene Entladeschwellwert SOC_10%_value, sodass in einem sich anschließenden Schritt S3' ein Nachladevorgang gestartet wird. Im Gegensatz zum mit Bezug auf Fig. 1 beschriebenen Ausführungsbeispiel des Verfahrens erfolgt hier kein Ermitteln des Kapazitäts-Kennwerts.

In einem sich anschließenden Schritt S4 wird die Nachladung bis zum Erreichen der Abschaltschwelle durchgeführt. Auch hier erfolgt ein Abschalten des Ladevorgangs, wenn der momentane Ladestrom I des Akkus die Abschaltschwelle I_end_cell unterschreitet. In einem sich anschließenden Schritt S7 wird ein in der Speicherelektronik des Akkus vorgesehener Ladevorgangszähler ccycles, der die Anzahl abgeschlossener Ladevorgänge repräsentiert, um 1 inkrementiert. Dies, da der Nachladevorgang unterbrechungsfrei abgeschlossen wurde.

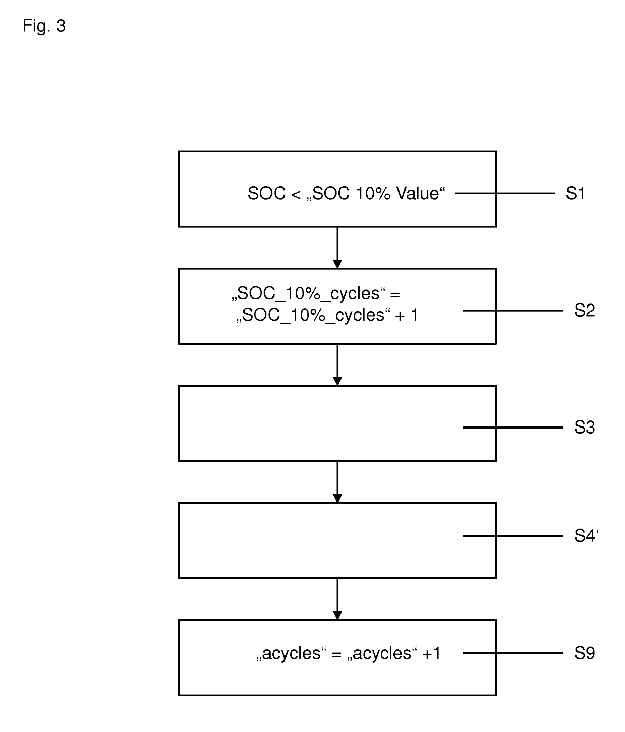

Ein abgebrochener Ladevorgang wird nunmehr mit Bezug auf Fig. 3 beschrieben. In einem ersten Schritt S1 wird wie auch bei dem mit Bezug auf Fig. 1 beschriebenen Ausführungsbeispiel ein entladener Akku, dessen SOC kleiner als die SOC_10%_value ist, mit dem Akku-Ladegerät verbunden. Dementsprechend wird in einem sich anschließenden Schritt S2 ein in der Speicherelektronik des Akkus vorgesehener Entladezustandszähler SOC_10%_cycles um den Wert 1 inkrementiert. Wie auch beim mit Bezug auf Fig. 1 beschriebenen Ausführungsbeispiel erfolgt in einem sich anschließenden Schritt S3 ein Ermitteln des Kapazitäts-Kennwerts durch das Akku-Ladegerät gleichzeitig zu einer Ladung des Akkus.

Im Gegensatz zu dem unterbrechungsfreien Ladevorgang der Fig. 1 wird in einem Schritt S4' in Fig. 3 ein Ladevorgang abgebrochen, exemplarisch durch ein Abziehen des Akkus von dem Akku-Ladegerät. In einem sich anschließenden Verfahrensschritt S9 wird ein in der Speicherelektronik des Akkus vorgesehener Ladeabbruchzähler acycles um den Wert 1 inkrementiert. Dies, da der Ladevorgang abgebrochen wird.

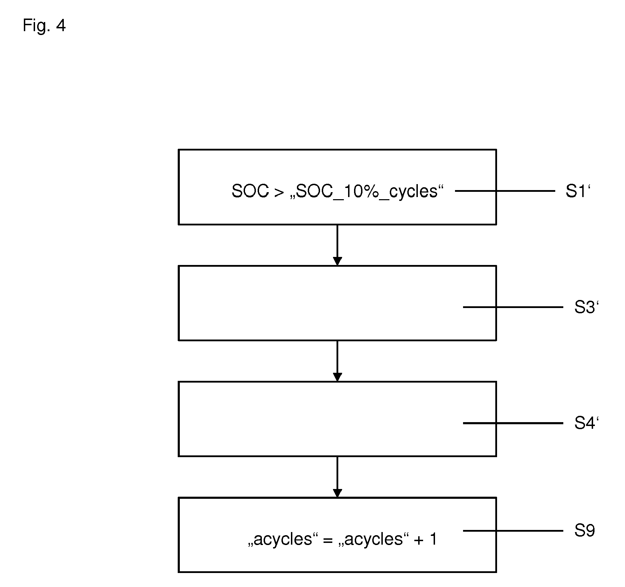

Fig. 4 zeigt nunmehr einen abgebrochenen Nachladevorgang. Dabei wird zunächst in einem ersten Schritt S1' ein Akku mit einem SOC = 0,2, das heißt > als SOC_10%_cycles mit dem Akku-Ladegerät verbunden. In einem sich anschließenden Schritt S3' wird der Akku mit einem Ladestrom I geladen, wobei keine Ermittlung des Kapazitäts-Kennwerts durch das Akku-Ladegerät erfolgt. Im Schritt S4' wird der Nachladevorgang abgebrochen, auch hier beispielhaft durch ein Abziehen des Akkus aus dem Akku-Ladegerät. Wie beim abgebrochenen Ladevorgang der Fig. 3 wird beim abgebrochenen Nachladevorgang der Fig. 4 in einem Schritt S9 der in der Speicherelektronik des Akkus vorgesehene Ladeabbruchzähler acycles um den Wert 1 inkrementiert, da der Nachladevorgang vor Erreichen des Endladezustands abgebrochen wurde.

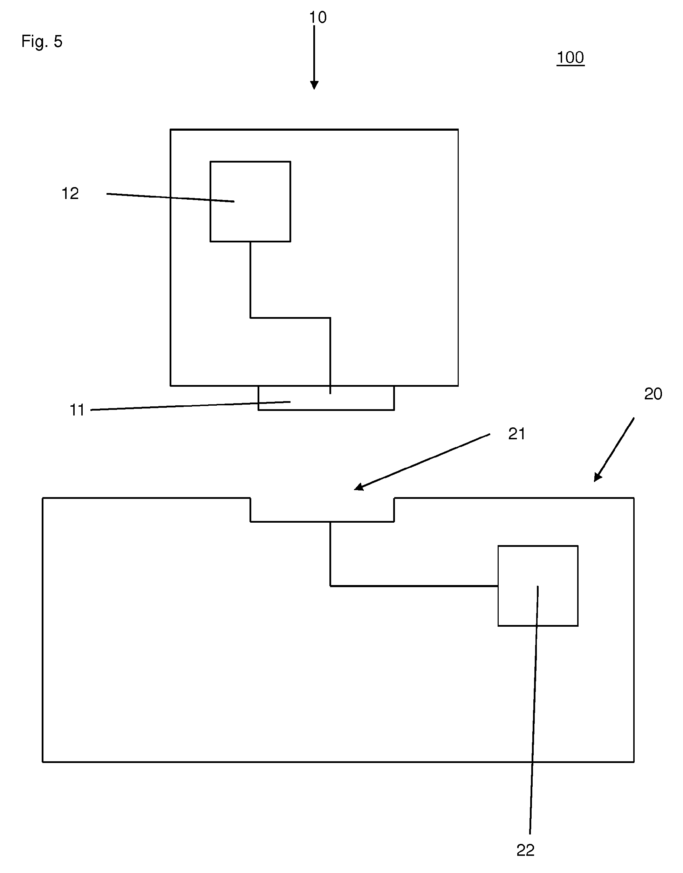

Ein erfindungsgemäßes Ladesystem 100 ist in Fig. 5 gezeigt. Das Ladesystem 100 weist einen Akku 10 und ein Akku-Ladegerät 20 zum Laden des Akkus 10 auf. Im vorliegend dargestellten Ausführungsbeispiel weist der Akku 10 eine Akku-Schnittstelle 11 auf, mittels der der Akku 10 in eine Ladegeräte-Schnittstelle 21 zwecks Aufladens des Akkus 10 eingeführt werden kann.

Das Akku-Ladegerät 20 weist ein Messmodul 22 zum Ermitteln eines Kapazitäts-Kennwerts des Akkus 10 auf. Das Messmodul 22 des Akku-Ladegeräts 20 ist dabei ausgebildet, den tatsächlichen in den Akku 10 fließenden Ladestrom I über den Ladezeitraum zu integrieren und somit einen Kapazitäts-Kennwert Cap_act des Akkus 10 zu ermitteln.

Über die Ladegeräte-Schnittstelle 21 des Akku-Ladegeräts 20 kann der Kapazitäts-Kennwert Cap_act an den Akku 10 über dessen Schnittstelle 11 übertragen werden. Erfindungsgemäß weist der Akku 10 eine Speicherelektronik 12 auf, in der der vom Akku-Ladegerät 20 erhaltene Kapazitäts-Kennwert Cap_act eingespeichert werden kann.

### Bezugszeichenliste

- Cap_act: Kapazitäts-Kennwert
- SOC_10%_value: Entladeschwellwert
- lend_cell: Abschaltschwelle
- cap_cycles: Kapazitätsermittlungszähler
- ccycles: Ladevorgangszähler
- SOC_10%_cycles: Entladezustandszähler
- acycles: Ladeabbruchzähler
- tcycles: Gesamtladevorgangszähler
- 100: Ladesystem
- 10: Akku
- 11: Akku-Schnittstelle
- 12: Speicherelektronik des Akkus
- 20: Akku-Ladegerät
- 21: Ladegerät-Schnittstelle
- 22: Messmodul

## Patentansprüche

1. Verfahren zum Ermitteln eines Ladungsspeichervermögens eines Akkus (10), insbesondere eines Handwerkzeugakkus, **gekennzeichnet durch** die Schritte:
- (S3) Ermitteln eines Kapazitäts-Kennwerts (cap_act), der ein Ladungsspeichervermögen des Akkus (10) repräsentiert, **durch** ein Akku-Ladegerät (20), und
- (S5) Einspeichern des **durch** das Akku-Ladegerät (20) ermittelten Kapazitäts-Kennwerts (cap_act) in einer Speicherelektronik (12) des Akkus (10).

2. Verfahren nach Anspruch 1,
**dadurch gekennzeichnet, dass** der Kapazitäts-Kennwert (cap_act) während eines Normalladevorgangs ermittelt wird, wobei der Normalladevorgang definiert ist durch ein Aufladen des Akkus (10) von einem Ladezustand unterhalb eines in dem Akku-Ladegerät (20) vorgegebenen Entladeschwellwerts (SOC_10%_value) bis zum Erreichen eines Endladezustands, für den im Akku-Ladegerät (20) eine Abschaltschwelle (lend_cell) vorgegeben ist.

3. Verfahren nach Anspruch 1 oder 2,
**gekennzeichnet durch** den Schritt:
- (S6) Inkrementieren eines in der Speicherelektronik (12) des Akkus (10) vorgesehenen Kapazitätsermittlungszählers (cap_cycles), der die Anzahl durchgeführter Ermittlungsvorgänge des Kapazitäts-Kennwerts (cap_act) repräsentiert, wenn der Normalladevorgang abgeschlossen wurde, bevorzugt nur wenn der Normalladevorgang abgeschlossen wurde und/oder der Normalladevorgang unterbrechungsfrei abgeschlossen wurde.

4. Verfahren nach einem der Ansprüche 1 bis 3,
**gekennzeichnet durch** den Schritt:
- (S7) Inkrementieren eines in der Speicherelektronik (12) des Akkus (10) vorgesehenen Ladevorgangszählers (ccycles), der die Anzahl abgeschlossener Ladevorgänge repräsentiert, wenn der Normalladevorgang oder ein Nachladevorgang unterbrechungsfrei abgeschlossen wurde, wobei der Nachladevorgang definiert ist **durch** ein Aufladen des Akkus (10) von einem Ladezustand oberhalb des in dem Akku-Ladegerät (20) vorgegebenen Entladeschwellwerts (SOC_10%_value) bis zum Erreichen des Endladezustands.

5. Verfahren nach einem der vorangehenden Ansprüche,
**gekennzeichnet durch** den Schritt:
- (S9) Inkrementieren eines in der Speicherelektronik (12) des Akkus (10) vorgesehenen Ladeabbruchzählers (acycles), der die Anzahl abgebrochener Ladevorgänge repräsentiert, wenn der Normalladevorgang oder der Nachladevorgang vor Erreichen des Endladezustands abgebrochen wurde.

6. Verfahren nach einem der vorangehenden Ansprüche,
**gekennzeichnet durch** den Schritt:
- (S2) Inkrementieren eines in der Speicherelektronik (12) des Akkus (10) vorgesehenen Entladezustandszählers (SOC_10%_cycles), wenn der Ladevorgang bei einem Ladezustand unterhalb des in dem Akku-Ladegerät vorgegebenen Entladeschwellwerts (SOC_10%_value) begonnen wird.

7. Verfahren nach einem der vorangehenden Ansprüche,
**gekennzeichnet durch** den Schritt:
- (S8) Summieren der im Ladevorgangszähler (ccycles) gespeicherten Anzahl abgeschlossener Ladevorgänge mit der im Ladeabbruchzähler (acycles) gespeicherten Anzahl abgebrochener Ladevorgänge in einen in der Speicherelektronik (12) des Akkus (10) vorgesehenen Gesamtladevorgangszähler (tcycles), bevorzugt nach, bevorzugt nur nach dem Ermitteln und/oder Einspeichern des Kapazitäts-Kennwerts (cap_act).

8. Verfahren nach einem der vorangehenden Ansprüche,
**gekennzeichnet durch** den Schritt:
- Auslesen des in die Speicherelektronik (12) des Akkus (10) eingespeicherten Kapazitäts-Kennwerts (cap_act) **durch** das Akku-Ladegerät (20) oder ein Akku-Diagnosegerät.

9. Verfahren nach einem der vorangehenden Ansprüche,
**gekennzeichnet durch** den Schritt:
- Subtrahieren der im Ladeabbruchzähler (acycles) gespeicherten Anzahl abgebrochener Ladevorgänge von einer Gesamtanzahl von Ladevorgängen, die im Gesamtladevorgangszähler (tcycles) gespeichert sind.

10. Akku (10), insbesondere Handwerkzeugakku, **gekennzeichnet durch** eine Speicherelektronik (12) in die ein **durch** ein Akku-Ladegerät (20) ermittelter Kapazitäts-Kennwert (cap_act) des Akkus (10) eingespeichert werden kann, die Speicherelektronik (12) weiter aufweisend:
- einen Kapazitätsermittlungszählers (cap_cycles), der die Anzahl durchgeführter Ermittlungsvorgänge des Kapazitäts-Kennwerts (cap_act) repräsentiert,
- einen Ladevorgangszähler (ccycles), der die Anzahl abgeschlossener Ladevorgänge repräsentiert,
- einen Ladeabbruchzähler (acycles), der die Anzahl abgebrochener Ladevorgänge repräsentiert, und/oder
- einen Entladezustandszähler (SOC_10%_cycles), der die Anzahl der Ladevorgänge angibt, die bei einem Ladezustand des Akkus unterhalb des in dem Akku-Ladegerät vorgegebenen Entladeschwellwerts (SOC_10%_value) begonnen werden.

11. Akku-Ladegerät (20) zum Laden eines Akkus (10), bevorzugt eines Akkus (10) nach Anspruch 10, aufweisend eine Ladegerät-Schnittstelle (21) über die ein durch das Akku-Ladegerät ermittelter Kapazitäts-Kennwert (cap_act), der ein Ladungsspeichervermögen des Akkus (10) repräsentiert, an den Akku (10) übertragen werden kann, zwecks eines Einspeicherns des ermittelten Kapazitäts-Kennwerts (cap_act) in eine Speicherelektronik (12) des Akkus (10).

12. Ladesystem (100) mit einem Akku (10) nach Anspruch 10 und einem Akku-Ladegerät (20) nach Anspruch 11, wobei das Ladesystem (100) ausgebildet ist ein Verfahren nach einem der Ansprüche 1 bis 9 auszuführen.
